Europäisches Patentamt

European Patent Office

Office européen des brevets

(11) Publication number: **0 030 154 B1**

(12) **EUROPEAN PATENT SPECIFICATION**

(45) Date of publication of patent specification: **02.05.85**

(51) Int. Cl.⁴: **H 02 J 9/00, G 01 R 31/36**

(21) Application number: **80304320.7**

(22) Date of filing: **01.12.80**

(54) **Testing emergency battery equipment.**

(30) Priority: **04.12.79 GB 7941838**

(43) Date of publication of application:
**10.06.81 Bulletin 81/23**

(45) Publication of the grant of the patent:
**02.05.85 Bulletin 85/18**

(84) Designated Contracting States:
**DE FR NL**

(56) References cited:
**DD-A- 98 420**
**DE-B-2 746 869**
**US-A-3 569 933**

**Patent Abstracts of Japan Vol. 2, No. 94, 05
August 1978 page 4523E78**

**Patents Abstracts of Japan Vol. 3, No. 30, 11
July 1979 page 86M65**

(73) Proprietor: **EMLUX LIMITED
Industrial Estate Black Bourton Road
Carterton Oxfordshire (GB)**

(72) Inventor: **Ford, Barry Stanley
21 Park Road Ducklington
Witney Oxfordshire (GB)**
Inventor: **Birkett, Sydney
Old School
Minster Lovell Oxfordshire (GB)**

(74) Representative: **Cline, Roger Ledlie et al
STANLEY, POPPLEWELL, POOLE 57 Lincoln's
Inn Fields
London WC2A 3LS (GB)**

Courier Press, Leamington Spa, England.

## Description

This invention relates to testing apparatus for testing battery equipment which is adapted for energization on mains failure. An example of such equipment is a battery powered light source. Such light sources are required by modern fire and factory regulations to cause all routes in a building leading to exit points to be illuminated in the event of a mains failure. Since batteries do not have an infinite life, even when they are not used, it is important that such light sources should be tested to ensure that they will work when an emergency occurs. The light sources are often placed high up on walls or on ceilings, so that it is inconvenient to make the tests by applying a meter to the lighting fitments themselves.

The battery powered equipment is usually provided with a charging circuit energized by the mains, and with a switch responsive to the presence of the mains supply to switch off the charging circuit and to connect the batteries to energize the equipment on failure of the mains supply. It has been proposed to test battery light sources by removing the mains supply from them, and then to inspect each battery light source to check that it is giving the desired illumination. Such inspection is liable to error, since a failed light source will not be visible and may easily be missed.

DE—B—2746869 discloses apparatus for monitoring the correct operation of a battery emergency lamp by simulating a mains cut-out condition, the test results being electronically stored in a monitoring memory and given a continuous display through a warning device. The mains cut-out condition can be started by means of a switch on the lamp itself or at a central point, and it is suggested that this latter switch can be replaced by an automatic time switch. This time switch at the central location would be energised by the general mains supply, and not the mains input to the testing apparatus. The breaking of the mains supply is only simulated, the switch causing the supply to an emergency lamp to be switched over to an emergency supply from the mains. The remaining components appear unaffected by the switching and a battery charged from a mains operated charger is continuously connected to the monitor.

The present invention is set out in claim 1 of the claims of this specification. This enables a much more compact arrangement to be produced so that the testing apparatus can be completely included within the existing housing of the standby battery equipment since the timing circuit breaks the mains supply to the whole of the standby equipment. Although the disclosure of DE—B—2746869 is a little confused, it appears that there are three mains supplies to various components of the apparatus and in practice a separate housing would have to be provided for this testing apparatus, distinct from the standby battery equipment.

When the standby equipment is a light source, the sensor is preferably a light sensor responsive to light from said light source to indicate when light from the light source is below a predetermined level.

The sensor may include an optical fibre for conducting light from the light source to a convenient location for the rest of the testing apparatus.

A further timing circuit may be provided to break the mains supply for a longer period than that caused by the first-mentioned timing circuit after a predetermined number of said intervals. During this longer period, the batteries will become discharged to a greater extent, which is useful since batteries such as nickel cadmium cells have a longer life if they are discharged and recharged at regular intervals.

Examples of the invention will now be described with reference to the accompanying drawings in which:

Figure 1 is a circuit diagram of an emergency light testing device,

Figure 2 is a circuit diagram of another emergency light testing device, and

Figure 3 is a detail of the circuit of Figure 2.

The light testing devices shown in the accompanying drawings perform similar functions. They receive a mains input on lines 11 and 12, they contain a switch 14 for controlling the energisation of the battery charging circuit (not shown) and they contain an alarm lamp 16 energised when the level of illumination detected by the sensor 15 falls below a predetermined level.

Each circuit contains two timing devices, the first 21 being arranged to operate approximately every two weeks, and the second 22 being arranged to operate about every 20 weeks. On operation of the first timing device 21, the mains supply is removed from the battery charging circuit, which causes the batteries to change from their charging mode to their discharging mode in which they energise the battery operated emergency light. A first time delay circuit 23 causes the power to be removed from battery charging circuit for a first predetermined period, and a second time delay circuit 24 causes the light sensor 15 to be energised a short time after the removal of power from the battery charging circuit so as to allow the battery powered lamp to reach full performance. A latching circuit 25 causes the alarm lamp 16 to be energised until reset, even after the end of the period of the time delay 23.

The alarm lamp 16 may be located adjacent the battery operated emergency lamp, or the lamps 16 from a plurality of emergency lamps may be located at a central position.

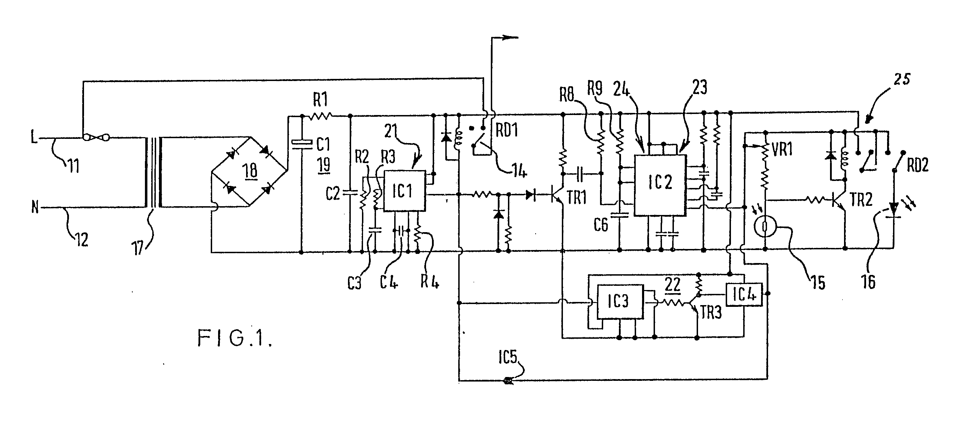

Turning now to Figure 1 in detail, mains power is supplied on the input lines 11 and 12 to a transformer 17 which produces 8 volts alternating current from its secondary winding which current is applied to a full wave diode rectifier 18 producing a 12 volt direct current output which is smoothed in a circuit 19 comprising capacitors C1 and C2 and resistor R1.

The timing device 21 comprises an integrated circuit IC1 (ZN1034E, see Radio Spares Information Sheet No. R2466), its time constant being governed by resistors R2, R3 and capacitor C3, and the self-triggering of the circuit being caused by components R4 and C4. The output of the circuit IC1 is a negative pulse, which energises a reed relay RD1 whose contacts form the switch 14 between the live mains input 11 and the battery charging circuit (not shown). When the timing device 21 times out, the negative pulse energises the coil of relay RD1, causing the switch contacts 14 to open, thus cutting off the charging circuit from the mains supply.

The output of circuit IC1 is also connected through a triggering inverting circuit including transistor TR1 (BC 148) to an integrated circuit IC2 (556, see Radio Spares Information Sheet No. R 2113) forming the time delay circuits 24 and 23 in series. The portion of the circuit IC2 forming the circuit 24 is controlled by resistors R8 and R9 and capacitor C6. The circuit 23 causes the light sensor 15 to be energised for a period of about three minutes after the short warming up delay of the circuit 24. If the sensor 15 senses a light output below a level controlled by the setting of potentiometer VR1, it causes the output of IC2 to energise transistor TR2 (BC 148) which energises a second reed relay RD2. This relay has two sets of contacts, the first set connecting the relay coil to the direct voltage supply from the smoothing circuit 19, thus holding the relay RD2 energised after the end of the period set by the circuit 23. A second set of contacts energises the alarm lamp 16 which is in the form of a flashing light emitting diode to indicate a failure of the emergency lighting supply. The diode 16 will continue to be energised even after the restoration of the mains supply on de-energisation of the relay RD1, since the relay RD2 has self-hold contacts. The diode 16 can be de-energised by manual re-setting of the relay RD2.

The integrated circuit IC1 causes the three-minute test to be carried out once every 2.7 weeks. The circuit of Figure 1 also arranges for a longer-period test to be carried out at less frequent intervals, and the timing device 22 which controls the frequency and timing of the longer test comprises an integrated circuit IC3 (4017: see Radio Spares Information Sheet No. R2949) which acts as a divide-by-ten circuit on the output of circuit IC1 and triggers an integrated circuit IC4 (555: see Radio Spares Information Sheet No. R2113) through a phase inverting circuit including transistor TR3 (ZN3053). The negative output of IC3 is converted to a positive signal by TR3 to energise the circuit IC4, which energises the light sensor 15 directly and the reed relay RD1 through a buffer integrated circuit IC5 (see Radio Spares Information Sheet No. R2949) for the period of one hour. The longer test of one hour is thus carried out in place of each tenth three-minute test, i.e. at 27 week intervals.

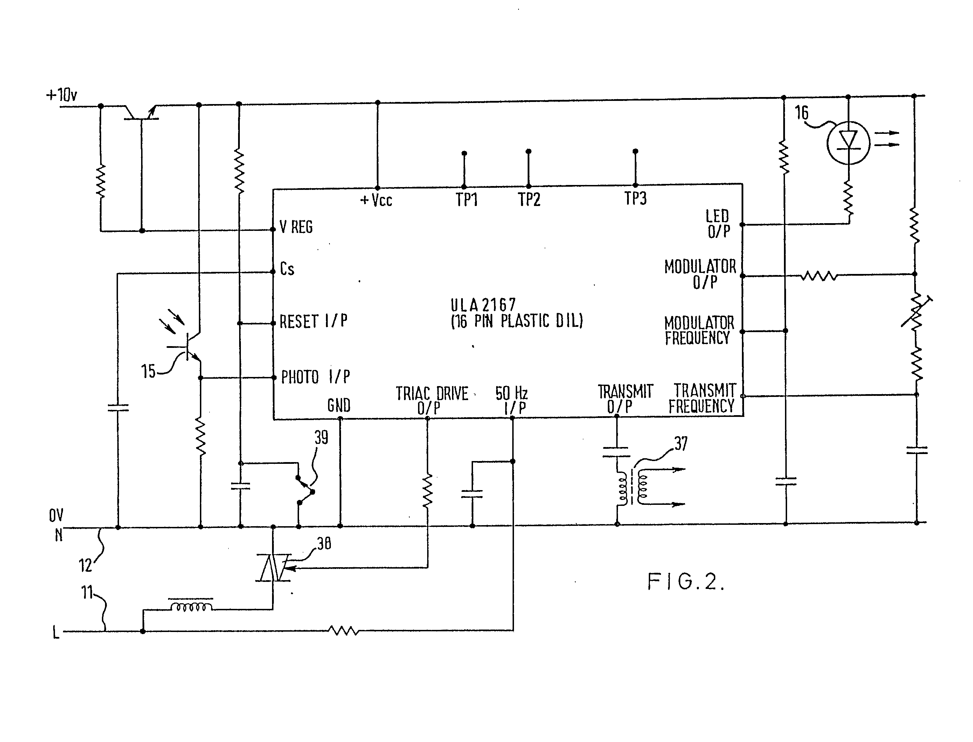

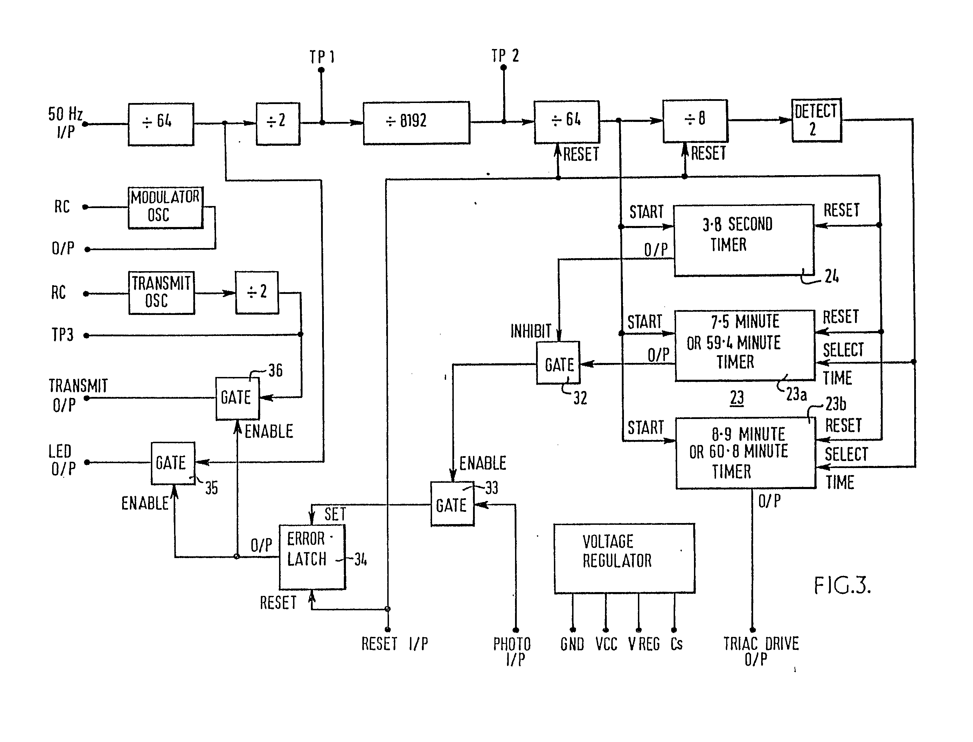

In the arrangement of Figures 2 and 3, the reed relays are replaced by solid state devices and various timing and delay circuits are included in a single integrated circuit ULA2167. The mains supply on line 11 is connected to the 50 Hz input pin of the integrated circuit, and the mains frequency is in turn divided by 64, 2,8192, 64 and 8. It will be seen that the second division by 64 provides a pulse approximately once every two weeks, and this pulse is used to start the time delay circuit 24 which in this case is a 3.8 second timer, and the time delay circuit 23 which in this case comprises a first timer 23a which can selectively time out after 7.5 minutes or 59.4 minutes and a second timer 23b, which can selectively time out at 8.9 minutes or 60.8 minutes. The selection of the short or long time of the two portions of the delay circuit 23 is controlled by a detector which detects the second of every eight counts from the final dividing circuit of the chain operating on the mains frequency input so that after the whole circuit is reset the first time-out period of the circuit 23 will be the shorter period, the second will be the longer period, and the third to eighth will be the shorter period. The output from the time delay circuit 23a is fed through a gate 32 and inhibited during the initial 3.8 seconds to allow time for the emergency lighting to warm up, after which it is passed to enable a gate 33 controlling the output of the light sensor 15 energised by a separate ten volt direct voltage supply to set an error latching circuit 34. The circuit 34 provides an output until reset which is fed to enable two gates 35 and 36, the gate 35 when enabled connecting the initial division of the mains frequency (with a period of 1.28 seconds) to energise the diode 16, so that the diode 16 thus flashes with this period. The second gate 36 when enabled connects a transmitting oscillator frequency, divided by two for convenience through a transformer 37 to an output circuit. By setting the frequency of the transmitter oscillator for each emergency lighting device at a different carrier frequency, the inputs from a plurality of testing devices may be connected to the same wire for transmission to a central location, the identity of the failed battery equipment being identified by the carrier frequency of the signal received.

The second portion 23b of the time delay circuit is used to operate a triac 38 which connects a coil across the mains input lines 11 and 12, energisation of the coil causing de-energisation of the battery charging circuit. At the start of each test, the triac will be energised by the circuit 23b so that the charging circuit is de-energised and the emergency battery lighting equipment brought into operation. After the 3.8 second delay, the light sensor 15 is energised and the test continues for 7.5 (or 59.4) minutes after the start of the test. The time delay circuit 23b continues the energisation of the triac for a further 1.4 minutes before reconnecting the battery charging equipment to the mains supply to prevent any spurious failure indications being generated.

The timing out of the circuits 23 does not cancel the energisation of the alarm lamp 16, since the latch circuit 34 remains latched. To cancel the alarm indication it is necessary to apply a re-set input to the latching circuit 34 by closing switch 39 and this should only be applied after the battery lighting equipment has been made serviceable. The re-set signal also re-sets the second divide by 64 circuit and the final divide by 8 circuit, so that the first subsequent test will be of the short period within the next two weeks, and the second test will be of the long period after a further two weeks.

The transmission of the failure signal from the output transformer 37 can be made over any convenient wire, for example a closed-circuit fire alarm, a pulsed clock system or a specially installed circuit exclusively for this purpose. As the output signal contains pulses of only milliwatts power, it should not affect any other circuits on the wire.

If the testing circuit should fail, the battery lighting equipment should still operate in the event of a mains failure, so that the testing system is fail-safe.

Optical fibres may be used to transmit light from the location of the stand-by equipment to a central station. The fibres may be used to transmit light from the battery equipment itself to a testing circuit at the central location, or they may be used to transmit light from diodes 16 of individual testing circuits at each location to the central location. If testing circuits are provided at the individual locations, it would be possible for the circuits to have a common set of timing devices, but individual sensors 15 and diodes 16.

The use of integrated circuits enables the testing circuits to occupy only a small volume, and thus they can be accommodated within the stand-by battery equipment if desired.

It is possible for another output of the stand-by equipment to be tested rather than the light output, for example the voltage supply from the batteries. In this case, the sensor 15 would be a potential sensor.

Test panels TP1, TP2 are provided on either side of the divide by 8192 divider in the chain of Figure 2 to allow injection of alternating signals to test operation of the circuit. The injected signals are of a sufficiently high frequency to cause the tests to be carried out faster than every 2 or 16 weeks.

## Claims

1. Testing apparatus for testing stand-by battery equipment which is adapted for energization on mains failure, the apparatus comprising a mains input (11, 12), a sensor (15) responsive to an output derived from the equipment when activated to indicate when the output is below a predetermined level, a timing circuit (21) to break the mains supply to the equipment automatically at regular intervals, characterised in that the timing circuit (21) is energized by said mains input (11, 12) and breaks the mains supply to the whole of the stand-by battery equipment for a series of testing periods and the apparatus comprises a power supply circuit (23) to cause the sensor (15) to be energized only during said testing periods.

2. Apparatus as claimed in claim 1, wherein said sensor (15) is adjustable to adjust said predetermined level.

3. Apparatus as claimed in claim 1 or claim 2, wherein said output is a light output.

4. Apparatus as claimed in claim 3, wherein said apparatus is located at a central station, and comprises a plurality of optical fibres leading respectively to a plurality of stand-by-battery equipments whose light output is to be tested.

5. Apparatus as claimed in any one of claims 1 to 4, comprising a further timing circuit (22) to break the mains supply for a longer period than that caused by the first-mentioned timing circuit (21) after a predetermined number of said intervals.

6. Apparatus as claimed in any one of the preceding claims, comprising means (24) to delay activation of the said sensor (15) for a period after disconnection of said mains supply from the stand-by equipment.

7. Apparatus as claimed in any one of the preceding claims, comprising a time delay circuit (23b) to delay reconnection of said mains supply to said stand-by equipment for a period after deactivation of said sensor (15).

## Patentansprüche

1. Prüfeinrichtung zum Überprüfen einer Bereitschafts- bzw. Notbatterie-Ausrüstung, die bei einem Netzausfall für eine Speisung geeignet ist, mit einem Netzeingang (11, 12), einem Fühler (15), der auf eine Ausgangsgröße der aktivierten Ausrüstung anspricht und anzeigt, wann die Ausgangsgröße unter einem bestimmten Pegel liegt, und einer Zeitschaltung (21) zum automatischen Unterbrechen der Verbindung zwischen der Netzversorgung und der Ausrüstung in regelmäßigen Intervallen, dadurch gekennzeichnet, daß die Zeitschaltung (21) durch den Netzeingang (11, 12) gespeist wird und die Verbindung zwischen der Netzversorgung und der gesamten Bereitschaftsbatterie-Ausrüstung für eine Reihe von Prüfperioden unterbricht, und daß die Einrichtung eine Leistungsversorgungsschaltung (23) aufweist, durch welche der Fühler (15) nur während der Prüfperioden gespeist wird.

2. Einrichtung nach Anspruch 1, dadurch gekennzeichnet, daß der Fühler (15) zum Einstellen des vorbestimmten Pegels einstellbar ist.

3. Einrichtung nach Anspruch 1 oder 2, dadurch gekennzeichnet, daß die Ausgangsgröße eine Licht-Ausgangsgröße ist.

4. Einrichtung nach Anspruch 3, dadurch gekennzeichnet, daß sie an einer zentralen Station angeordnet ist und eine Mehrzahl von optischen Fasern aufweist, die entsprechend zu einer Mehrzahl von Bereitschaftsbatterievorrichtungen führen, deren Licht-Ausgangsgröße zu überprüfen ist.

5. Einrichtung nach einem der Ansprüche 1 bis 4, gekennzeichnet durch eine weitere Zeitschaltung (22) zum Unterbrechen der Netzversorgung während einer längeren Periode als derjenigen, die durch die erste Zeitschaltung (21) verursacht wird, nach einer vorbestimmten Anzahl der Intervalle.

6. Einrichtung nach einem der vorhergehenden Ansprüche, gekennzeichnet durch Mittel (24) zum Verzögern der Aktivierung des Fühlers (15) während einer Periode nach dem Abtrennen der Netzversorgung von der Bereitschaftsvorrichtung.

7. Einrichtung nach einem der vorhergehenden Ansprüche, gekennzeichnet durch eine Zeitverzögerungsschaltung (23b) zum Verzögern des Wiederanschließens der Netzversorgung an die Bereitschaftsvorrichtung während einer Periode nach dem Entaktivieren des Fühlers (15).

**Revendications**

1. Appareil de test pour contrôler un équipement à batterie de secours qui est adapté pour être mis en oeuvre en cas de panne du secteur, cet appareil comportant une entrée (11, 12) du secteur, un dispositif sensible (15) répondant à une sortie provenant de l'équipement, lorsqu'il est mis en oeuvre, pour indiquer quand cette sortie est inférieure à un niveau prédéterminé, un circuit séquenceur (21) pour couper l'alimentation du secteur vers l'équipement, automatiquement et à des intervalles régulier, caractérisé en ce que le circuit séquenceur (21) est mis sous tension par l'entrée du secteur (11, 12) et coupe l'alimentation du secteur sur l'ensemble de l'équipement à batterie de secours pour une série de périodes de test et en ce que l'appareil comporte un circuit de fourniture de tension (23) pour permettre que le dispositif sensible (15) soit mis en oeuvre seulement pendant les périodes de test.

2. Appareil selon la revendication 1 caractérisé en ce que le dispositif sensible (15) est ajustable pour régler le niveau prédéterminé.

3. Appareil selon l'une des revendications 1 ou 2 caractérisé en ce que la sortie est une sortie de lumière.

4. Appareil selon la revendication 3 caractérisé en ce qu'il est disposé dans une station centrale et comporte une pluralité de fibres optiques conduisant respectivement à une pluralité d'équipements à batterie de secours dont les sorties de lumière sont à tester.

5. Appareil selon l'une quelconque des revendications 1 à 4, caractérisé en ce qu'il comporte également un circuit séquenceur additionnel (22) pour couper l'alimentation du secteur pendant une période plus longue que celle produite par le premier circuit séquenceur (21) après un nombre prédéterminé des intervalles.

6. Appareil selon l'une quelconque des revendications 1 à 5 caractérisé en ce qu'il comporte des moyens (24) pour retarder l'excitation du dispositif sensible (15) pendant une certaine période de temps après déconnexion de l'alimentation du secteur sur l'équipement de secours.

7. Appareil selon l'une quelconque des revendications précédentes caractérisé en ce qu'un circuit temporisateur (23b) est prévu pour retarder la reconnexion de la tension du secteur à l'équipement de secours d'une certaine période de temps après la désexcitation du dispositif sensible (15).

FIG.1.

L 11
N 12
17
18
19
C1
C2
R1
R2 R3
21
IC1
C3 C4 R4
RD1
14
TR1
R8 R9 24 23
IC2
C6
22
IC3 TR3 IC4
IC5
VR1
15
TR2
16
RD2
25

FIG.2.

+10v

+Vcc TP1 TP2 TP3

V REG

Cs

RESET I/P

PHOTO I/P

GND TRIAC DRIVE O/P 50 Hz I/P TRANSMIT O/P

ULA 2167
(16 PIN PLASTIC DIL)

LED O/P

MODULATOR O/P

MODULATOR FREQUENCY

TRANSMIT FREQUENCY

16

15

39

38

37

12

11

OV
N

L

0 030 154

2

FIG.3.